(19) **Europäisches Patentamt** / **European Patent Office** / **Office européen des brevets**

(11) **EP 3 686 614 B1**

(12) **EUROPEAN PATENT SPECIFICATION**

(45) Date of publication and mention
of the grant of the patent:
**18.10.2023 Bulletin 2023/42**

(21) Application number: **19189165.4**

(22) Date of filing: **30.07.2019**

(51) International Patent Classification (IPC):
**G01R 22/10** (2006.01)  **G01R 31/36** (2020.01)
**G01R 31/392** (2019.01)

(52) Cooperative Patent Classification (CPC):
**G01R 22/10; G01R 31/3648; G01R 31/392**

(54) **METHOD AND APPARATUS FOR METERING POWER CONSUMPTION OF A DIGITAL SOC FOR PREDICTING BATTERY LIFE**

VERFAHREN UND VORRICHTUNG ZUR MESSUNG DES LEISTUNGSVERBRAUCHS EINES DIGITALEN SOC ZUR VORHERSAGE DER BATTERIELEBENSDAUER

PROCÉDÉ ET APPAREIL DE MESURE DE LA CONSOMMATION D'ÉNERGIE D'UN SYSTÈME SUR PUCE NUMÉRIQUE PERMETTANT DE PRÉDIRE LA DURÉE DE VIE DE BATTERIES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **23.01.2019 EP 19153216**

(43) Date of publication of application:
**29.07.2020 Bulletin 2020/31**

(73) Proprietor: **SHENZHEN GOODIX TECHNOLOGY CO., LTD.**
**Shenzhen, Guangdong 518045 (CN)**

(72) Inventor: **Hesse, Kay**
**01129 Dresden (DE)**

(74) Representative: **Lippert Stachow Patentanwälte Rechtsanwälte**
**Partnerschaft mbB**
**Krenkelstraße 3**
**01309 Dresden (DE)**

(56) References cited:
**EP-A1- 2 670 034**    **KR-B1- 101 571 932**
**US-A1- 2011 093 733**    **US-A1- 2013 024 713**
**US-A1- 2013 151 228**

**Description**

The invention discloses a method for metering power consumption of a digital system-on-chip (SoC) for predicting battery life of a battery used by the SoC.

The invention also discloses an apparatus for performing the method of metering power consumption of a SoC.

Battery-powered devices are ubiquitous and cover a wide range of applications - from laptop computers to smart phones to small distributed sensors. Predicting end of battery life, or requirement to re-charge is important for most of these applications, either to provide a good user experience or prevent disruption of service. Especially small IoT devices pose a set of specific challenges, depending on their field of application: They are typically using small, non-rechargeable batteries, they are supposed to last for years in remote places, they might not be easily serviceable (e. g. buried sensors) and the application may still require an advanced indication of imminent battery loss. US 2013/0151228 A1 provides a power consumption prediction method for an integrated circuit device in order to estimate the power consumption of the IC device based on a power consumption model.

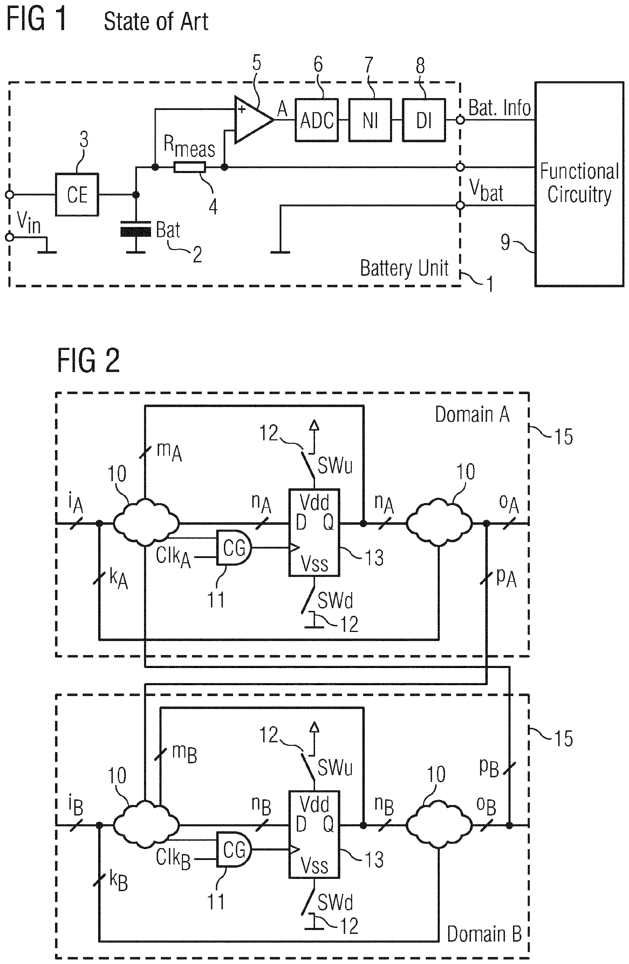

Figure 1 shows a state-of-the-art battery monitoring 1, which is used in a variety of mobile devices, e.g. smart phones or laptop computers. The battery monitoring 1 comprises the following main parts: The actual battery *Bat* 2, which is typically a Lithium-Ion or Lithium-Polymer cell in today's devices. It further comprises the charge electronic CE 3, which ensures a safe recharge of the battery 2 as well as a small series resistor $R_{meas}$ 4 (in the order of 1mΩ) to convert the current into a voltage. A differential amplifier A 5 is used to pre-process the voltage for the following units and an analog-to-digital converter (ADC) 6 converts the amplified voltage into a numerical value. A numerical integration (NI) block 7 accumulates the samples to calculate the drained charge from the battery, whereas a digital interface (DI) 8, typically I2C or SPI, uses the actual functional electronics to query the battery state. Last but not least, the actual functional circuitry 9 which is driven from the battery 2 can be anything from a smart phone's SoC to the motherboard of a laptop computer and it uses the digital interface 8 to learn about the battery state (and most likely communicates it to the user) using a built-in micro-controller.

As indicated in figure 1, the battery monitoring electronics 1 is often part of the battery pack itself and would thus be replaced along with it. Today, the charge electronics CE 3, the amplifier A 5, the *ADC* 6 with the numerical integration *NI* 7 and the digital interface *DI* 8 are all integrated into a single mixed-signal chip. It has the advantage, that this method of current metering covers all possible contributors of a platform and, since the metering chip is part of the battery pack 1, it can report the remaining battery charge right away, since it knows the battery size. But the measurement resistor $R_{meas}$ 4 is mostly a discrete part because of the high currents flowing through and the accuracy required for exact measurements. This approach, however, adds both cost and printed circuit board (PCB) area to the platform that would not be acceptable for small, low-cost IoT systems. For example, in EP 2 670 034 A1, which discloses a method of determining the input current consumption of a capacitive DC/DC converter, external components are needed to predict the battery life of a battery which supplies current to a load through the capacitive DC/DC converter.

It is therefore the object of the invention to find a possibility to observe and meter the battery life of small, low-cost SoC, especially IoT systems, which is cheap and compact and space-saving, and which can avoid the need for external components.

The object of the invention will be solved by a method for metering power consumption of a digital system-on-chip for predicting battery life of a battery used by the SoC according to independent claim 1.

The method comprising the following steps:

- Partitioning of all digital circuitry of the SoC into voltage and/or clock domains;
- Metering a power consumption of every domain by counting a charge pulse of each domain every time a gate of said domain has been switched;
- Accumulating said counted charge pulses of each domain by an accumulator, wherein the value of counted charge pulses of each domain is proportional to its gate-count, the average switching activity, and the square of the domain's voltage;
- Calculating an overall sum *R* of all charges drained from the battery by said domains of the SoC;
- Post-processing said overall sum R for predicting battery life by an integrated micro-processor;
- Signaling an imminent battery loss.

The basic idea of the invention is to keep the numeric integration of the prior-art approach, but remove the series resistor and analog-to-digital converter (ADC) altogether and move the metering into the SoC. Instead, the current is determined by proxy of activity metering inside a SoC and post-processing the results with an integrated micro-processor.

Starting from the point that the power dissipation of a digital circuit in general is the sum of two main contributors: leakage power and dynamic power - $P_{tot} = P_{leak} + P_{dyn}$ (eq. 1). For battery life prediction, though, the charge drained from the battery is the more important value: $Q_{tot} = Q_{leak} + Q_{dyn} = \int \frac{U}{R_{leak}} dt + \int U \cdot C_{sw} \cdot f dt$ (eq. 2), and $C_{sw}$ is the parasitic capacitance that is recharged with every clock cycle. This capacitance, however, is not constant but depends on the actual circuit (e. g. clock gating domains) and even the actual values being processed (e. g. the output of an AND gate only changes when switching between a state where all inputs are '1' and at least one input is '0'). Finally, $f$ is the current switching frequency. This value typically is not only changed over time (frequency scaling), but also different between different parts of a SoC (clock domains). During periods t with a constant voltage eq. 2 can be simplified to:

$$Q_{tot} = U \cdot const \cdot \Delta t + U \cdot \int_{t}^{t+\Delta t} C_{sw} \cdot f dt \quad \text{(eq. 3)}.$$

The dynamic part of eq. 3 can be further transformed to

$$Q_{dyn} = U \cdot \sum_{d}^{clk\_domains} \int_{t}^{t+\Delta t} C_{sw,d} \cdot f_d dt \quad \text{(Eq. 4)},$$

and using a clock domain specific effective capacitance $C_{eff,d}$ instead of the actual value-dependent $C_{sw;d}$ this can be further simplified to

$$Q_{dyn} = U \cdot \sum_{d}^{clk\_domains} C_{eff,d} \cdot f_d \Delta t \quad \text{(eq. 5)},$$

whereas d indicates the respective domain.
Putting everything together, this leads to

$$Q_{tot} = \sum_{v}^{volt\_intv} U_v \cdot \left[ const \cdot \Delta t_v + \sum_{d}^{clk\_domains} C_{eff,d} \cdot f_d \Delta t_v \right] \quad \text{(eq. 6)},$$

i. e. the total charge drained is the sum over all intervals (*volt_intv*) with constant voltage $U_v$ and the inner sum over all clock domains (*clk_domains*).
On an abstract level all digital circuitry of a SoC can be considered as communicating Mealy-automata. So, the SoC can be partitioned into voltage and/or clock domains, whereas a domain may be an individual clock domain within a more common voltage domain or a domain may be a voltage domain with a single clock domain or in principle a domain may be a voltage domain within a more common clock domain. However, this case is typically handled by breaking the common clock domain into two physical clock domains to ease physical implementation (it can still be considered the same logical clock domain, though).
Each domain has its own gate count, may run different clock speeds and even different voltages. Nevertheless, it still boils down to a certain energy (or charge) per time-unit t that is used in a specific domain d.
In the sense of this invention a domain comprises a purely combinational logic of arbitrary complexity, a group of sequential elements (flip-flops) that store state between subsequent clock cycles, a clock gate, i.e. a circuit that switches a clock glitch-free on and off, based on a condition, and a power switch. For the power metering procedure each clock domain comprises a N-to-1 divider that provides a counting pulse for the accumulation. The factor $N_d$ is a compromise between accuracy, an averaging interval and the fact that the accumulation itself contributes to the power consumption (and the more frequent the accumulators are updated the more power the metering consumes itself). In the extreme, $N_d$ could be set to 1, but this would result in a higher power consumption of the metering and the requirement for wider accumulators (since these would be updated more often).
The accumulator assigned to a domain accumulates the respective domain's charge value. The accumulators can be separated or integrated into their respective domains.
Partitioning of all digital circuitry of the SoC into voltage and/or clock domains is done at design time and mostly is necessary for backend/synthesis tasks, anyway.
In a preferred embodiment of the inventive method, the overall sum R of charges of all domains is calculated by $R = S_d \cdot \sum_{i}^{pulses} I_d$, whereas $S_d$ corresponds to a domain scaling factor and $I_d$ corresponds to a domain-specific increment.
In another preferred embodiment of the inventive method, $I_d$ and $S_d$ represents a combined proportionality factor of the domain and they depend on the gate-count of said domain, the switching activity of said domain and the voltage of said domain.

In another further preferred embodiment of the inventive method, and since the gate-count of each domain is fixed at design time of the SoC and is thus constant, the switching activity is determined by netlist simulations at design time or by a calibration step of the SoC, which can be done e. g. during production test and measure the power consumption under known conditions (voltage levels and clock speeds).

The gate-count is fixed at design time and is thus constant. The switching activity in general depends on the circuit's inputs (and clock frequency) and may be determined by netlist simulations at design time or only later by calibration on real silicon.

In another further preferred embodiment of the inventive method, $I_d$ and/or $S_d$ are adjusted to a current voltage selection of the domain, whereas $I_d$ and/or $S_d$ are reprogrammed dynamically by the integrated micro-processor or by an automatic voltage selector.

In the presence of voltage scaling, either the $I_d$ or $S_d$ must be adjusted according to the voltage. That and the potential calibration for the switching activity make it necessary to reprogram the $I_d$ or $S_d$ dynamically. If $I_d$ is set to 1 and an integrated processor carries out the scaling and final summation, the reprogramming is easily done within the realm of that processor. Otherwise, the $I_d$ or $S_d$ could be programmable registers in hardware or ROM-based lookup-tables to account for the voltage dependency. In case of automatic voltage scaling (i. e. not under software control) a hardware extension is necessary.

In a preferred embodiment of the inventive method, nested clock domains are handled by identifying an appropriate level of clock domains, numerically integrating of their respective activity and averaging over all potential sub-domains.

In today's SoCs it is typical that clock domains are nested. Nesting may be implemented explicitly by the designer or may be inferred automatically by synthesis tools. The inventive method can deal with nested clock domains in two possible ways: Firstly, it can instrument each sub-domain with the N-to-1 divider and accumulator structures, or secondly, it can treat sub clock domains simply as parts of their parent domain with just a reduced switching activity and adjust the $I_d$ (or $S_d$ appropriately). The important step is to identify the appropriate level of clock domains for numeric integration of their respective activity and averaging over all potential sub-domains. Too small a domain will unduly increase the metering overhead; too big a domain will impair the metering accuracy. The factors that correspond to the domain's $C_{eff;d}$ can be determined either by pre-silicon simulation (RTL or netlist) or characterization of the actual silicon. These factors, together with the desired accuracy/overhead compromise, will then be taken to define the level of clock domains at design time.

So, in an embodiment of the inventive method dealing with nested domains, the factors $I_d$ and/or $S_d$ are determined by netlist simulations at design time or by a calibration step of the SoC.

In a further preferred embodiment of the inventive method, a top accumulator is pre-set with a credit reflecting a battery capacity from which the accumulated charges of each domain are subtracted until said credit has expired and the battery has reached its end of life.

Instead of summing up the metered charges by the accumulators shown above, it would also be possible to pre-set the top accumulator with a "credit" that reflects the battery capacity (minus a reasonable safety margin) and then constantly subtract from that. When that credit has expired the battery has reached its end of life (or needs to be recharged). This alternative approach is very easy to implement since software needs to know about the battery size to take appropriate action in the case of imminent battery loss.

The object of the invention will also be solved by an apparatus which is appropriate for performing the inventive method of metering power consumption of a SoC, especially an IoT UE. The inventive apparatus is part of the SoC and comprises all digital circuitry of the SoC, wherein said digital circuitry is divided into clock and/or voltage domains, whereas each domain is assigned to an accumulator for accumulating counted charge pulses of said domain, a collection means for calculating an overall sum R of all charges drained from the battery by said domains of the SoC and a micro-processor for post-processing said overall sum R for predicting battery life of the SoC.

In an embodiment of the inventive apparatus, each domain comprises combinational logic, a clock gate for switching a clock, storage means for storing a state between subsequent clock cycles and a N-to-1 divider for providing a counting pulse for the accumulation.

In each clock domain a N-to-1 divider is added that provides a counting pulse for the accumulation. The factor $N_d$ is a compromise between accuracy, an averaging interval and the fact that the accumulation itself contributes to the power consumption (and the more frequent the accumulators are updated the more power the metering consumes itself). In the extreme, $N_d$ could be set to 1, but this would result in a higher power consumption of the metering and the requirement for wider accumulators (since these would be updated more often).

In another embodiment of the inventive apparatus, the accumulator comprises a domain-specific increment register. This register contains a domain-specific increment $I_d$ indicating an individual characteristic of a respective domain.

In another further embodiment of the inventive apparatus, the calculation means comprises a domain scaling factor register. This means, that for the calculation a domain scaling factor register is used. This register contains a domain scaling factor $S_d$ indicating the consumed charge per metering pulse.

In an embodiment of the inventive apparatus, the domain-specific increment register and/or the domain scaling factor register are programmable registers or ROM-based look-up-tables.

In a further embodiment of the inventive apparatus, each domain comprises a voltage selector for dynamic voltage scaling.

Summarizing, the inventive method and apparatus for metering power consumption of a digital SoC with the goal of predicting battery life, has the following advantages over the current state-of-the-art:

- The apparatus perform the inventive method without any analog or mixed-signal circuitry, making it easy to integrate the procedure into a digital chip. It also does not require any discrete parts (like measurement resistors).
- The hardware requires only little gate count overhead to implement and adds virtually no cost.
- The invention can be applied to a variety of SoCs, with virtually any gate count.
- The method described is independent of the actual silicon technology.
- The metering method works for both, rechargeable and non-rechargeable batteries.
- The method is compatible with dynamic voltage/frequency scaling approaches widely applied in the industry.

The presented approach needs to work around an intrinsic drawback it has against the known prior art method: With the charge/power metering sitting directly at the battery the prior-art method will automatically cover all contributors in a multi-chip platform (like e. g. a smart phone with radio, modem chip, application processor and display). The novel and inventive method needs to collect metering information from all individual digital chips instrumented as described in the invention and additionally model the contributions from non-digital parts (like e. g. a radio chip). This, however, is less of a limitation as one would think: typically the software collecting all the metering information would control the platform and thus knows about the activity of these extra components. It is then only a matter of sufficiently exact power consumption approximations for these extra components. The metering method presented here does not strive to achieve an absolutely exact number of battery discharge, but merely a result with reasonable margin allowing predicting the end of battery life in the near future.

The invention will be explained in more detail using exemplary embodiments.

The appended drawings show

Fig. 1    State-of-the-art battery monitoring;

Fig. 2    Illustration of partitioning into voltage/clock domains;

Fig. 3    Illustration of the inventive power metering with local accumulation;

Fig. 4    Extension for dynamic voltage scaling;

Fig. 5    Embodiment of the inventive power metering with combined collection and accumulation;

Fig. 6    Illustration of nested clock domains.

Figure 2 shows two domains 15 exemplifying the possible partitioning of the digital circuitry 9 of a system-on-chip (SoC) into domains. On an abstract level all digital circuitry of a SoC can be considered as communicating Mealy-automata. A domain may be an individual clock domain within a more common voltage domain, or a domain may be a voltage domain with a single clock domain, or in principle a domain may be a voltage domain within a more common clock domain. However, this case is typically handled by breaking the common clock domain into two physical clock domains to ease physical implementation (it can still be considered the same logical clock domain, though).

The symbols used in figure 2 have the following meaning: The "clouds" represent purely combinational logic 10 of arbitrary complexity.

The AND-symbol marked with "CG" represents a clock gate 11, i. e. a circuit that switches a clock glitch-free on and off, based on a condition (typically a combination of a latch and an AND in physical implementation).

The flip-flop 13 symbol stands proxy for a vector of sequential (clocked) elements that store state between subsequent clock cycles.

The two switch symbols "SWu" and "SWd" represent power switching 12. It should be noted that in any real silicon only one of them is used. Whether it is switching against ground ("footer switches") or Vdd ("header switches") depends on the actual technology, but has no influence on this invention.

The vectors connecting the parts have the following meaning:

- $i_x$: Primary input vector of the domain.
- $o_x$: Primary output vector of the domain.
- $n_x$: State vector of the domain (identical to the number of sequential elements in the domain).
- $m_x$: The feedback vector from state to next-state logic.
- $k_x$: The vector of primary inputs that contribute to the output vector through purely combinational logic.
- $p_x$: The cross-domain forwarding vector.

Each depicted domain 15 in figure 2 has its own gate count, may run at different clock speeds and even different voltages. Nevertheless, it still boils down to a certain energy (or charge) per time-unit t that is used in a specific domain d.

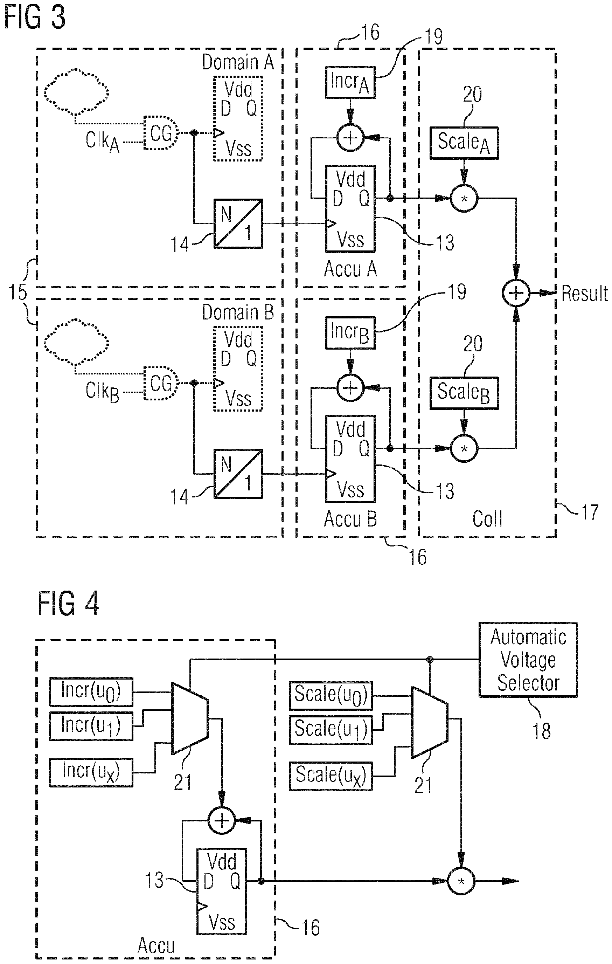

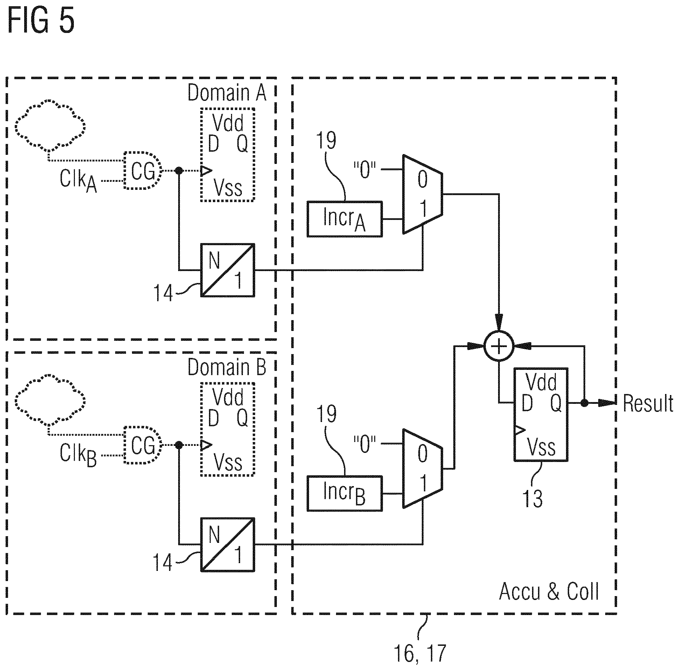

Figure 3 shows an embodiment of the present inventive power metering procedure translating eq. 6 into the requirement to numerically integrate (accumulate) a value for each domain that is proportional to its gate-count, the average switching activity, and the square of the domain's voltage. Figures 3 and 5 show two potential embodiments.

Figure 3 refers to the domains 15 from figure 2 but just depicts the important additions for power metering. In each clock domain 15 a N-to-1 divider 14 is added that provides a counting pulse for the accumulation 13.

The factor $N_d$ is a compromise between accuracy, an averaging interval and the fact that the accumulation itself contributes to the power consumption (and the more frequent the accumulators are updated the more power the metering consumes itself). In the extreme, $N_d$ could be set to 1, but this would result in a higher power consumption of the metering and the requirement for wider accumulators (since these would be updated more often).

The structures in figure 3 marked as "Accu A" and "Accu B" are the accumulators 16 for the respective domain's charge values. They are shown somewhat separated but could also be integrated into their respective domains 15. The structure marked as "Coll" 17 calculates the overall sum $R$ of all domain's contributions. In essence, the circuitry of figure 3 calculates eq. 6 by proxy: $Q \sim R = \sum_d^{domains}\left(S_d \cdot \sum_t^{pulses} I_d\right)$ (eq. 7) with $R$ representing the result, $S_d$ corresponding to the domain scaling factors $Scale_{A|B}$ 20, and $I_d$ corresponding to the domain-specific increments $Incr_{A|B}$ 19.

It should be noted that there is some freedom in implementation to calculate eq. 7. Either the $I_d$ or the $S_d$ can be set to 1. If $I_d$ is set to 1 then this has the advantage that the local accumulators 16 can be implemented with fewer bits and only the multipliers and final sum need to be wide. When $S_d$ is set to 1 then the multipliers become simple wires, but the local accumulators need to be wider. Which implementation is chosen also depends on where the boundary between hardware and software is drawn. If the SoC has an integrated processor, which would often be the case, then this can take over the multiplication, collection and final accumulation of the result. In this case setting the $I_d$ to 1 is advantageous since this saves gates and the integrated processor typically has the necessary multiplier unit, anyway.

There is another aspect to the $I_d$ and $S_d$, respectively: Since they represent the combined proportionality factor they depend on the domain's gate-count, the switching activity and the voltage. The gate-count is fixed at design time and is thus constant. The switching activity in general depends on the circuit's inputs (and clock frequency) and may be determined by netlist simulations at design time or only later by calibration on real silicon. In the presence of voltage scaling, either the $I_d$ or $S_d$ must be adjusted according to the voltage. That and the potential calibration for the switching activity make it necessary to reprogram the $I_d$ or $S_d$ dynamically. If $I_d$ is set to 1 and an integrated processor carries out the scaling and final summation, the reprogramming is easily done within the realm of that processor. Otherwise, the $I_d$ or $S_d$ could be programmable registers in hardware or ROM-based lookup-tables to account for the voltage dependency. In case of automatic voltage scaling (i. e. not under software control) a hardware extension as depicted in figure 4, is necessary. It shows essentially a section of figure 3 (one accumulator 16 and scaling multiplier 20) with the logic for the dynamic adjustment of the $I_d$ or $S_d$ based on the current voltage selection, depicted as multiplexers 21 selecting one value out of a set based on the current voltage selection.

Figure 5 shows another, more hardware-centric embodiment to implement eq. 7. In this case the counting pulses from each domain 15 contribute immediately to the overall sum $R$ using their individual increments $I_d$ 19. Based on what was explained previously, it should be clear that the $I_d$ need to be dynamically adjustable in case of voltage scaling. This would either be done by changing the $I_d$ through the integrated processor or using the extensions shown in figure 4. It should be mentioned that simple voltage-switching does not require dynamic adjustment of the $I_d$, because during the off-time of a domain there are simply no count pulses. The embodiment according to figure 5 would typically still use a processor in the SoC to process the metered result and potentially notify the user of imminent battery loss.

It should be mentioned that for the scope of this invention an integrated processor of the SoC is also just a (set of) voltage/clock domain(s) that is metered along with all other domains. The complete metering needs a combination of hardware and software; hence the inventive apparatus is also called "hybrid power metering". The hardware would do the low-level metering on a per-domain basis during intervals with constant parameters (voltage, switching activity). Software is then responsible for integrating the domain's results and would adjust the parameters accordingly. Since firmware would control the SoC power states (voltage scaling, power-switching) anyway, it can easily apply the correct parameters for the respective metering intervals.

In another embodiment it is possible instead of summing up the metered charges by the accumulators 16 shown above, to pre-set the top accumulator with a "credit" that reflects the battery capacity (minus a reasonable safety margin) and then constantly subtract from that. When that credit has expired the battery has reached its end of life (or needs to be recharged). This alternative approach is very easy to implement since software needs to know about the battery size to take appropriate action in the case of imminent battery loss.

It should be clear for the person skilled in the art that the embodiments according to figures 3 and figure 5 are but two possibilities out of a whole spectrum. It would be straightforward to apply figures 3 and figure 5 to different sections of a more complex SoC and then combine their results.

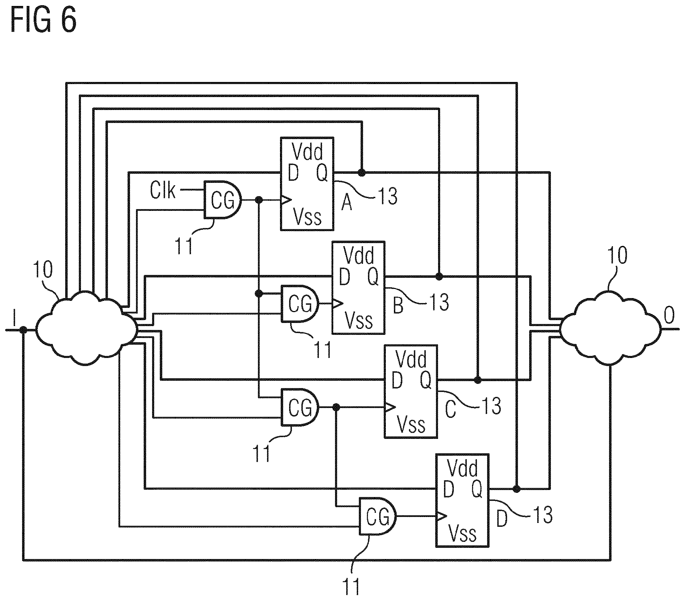

While figures 3 and figure 5 only show flat clock domains 15, it is more typical in today's SoC's that clock domains are nested, as shown in figure 6. Nesting may be implemented explicitly by the designer or may be inferred automatically by synthesis tools. In figure 6 the top clock domain would drive all registers marked as "A". There are two direct sub-domains "B" and "C" that further condition the clocks (with individual conditions). Domain "D" is yet one more sub-level of "C". The inventive method can deal with this situation in two possible ways: Firstly, it can instrument each sub-domain with the N-to-1 divider and accumulator structures shown in figures 3 and figure 5; or secondly, it can treat sub clock domains simply as parts of their parent domain with just a reduced switching activity and adjust the $I_d$ (or $S_d$ appropriately) .

The important step is to identify the appropriate level of clock domains for numeric integration of their respective activity and averaging over all potential sub-domains. Too small a domain will unduly increase the metering overhead; too big a domain will impair the metering accuracy. The factors that correspond to the domain's $C_{eff;d}$ can be determined either by pre-silicon simulation (RTL or netlist) or characterization of the actual silicon.

**List of Reference Signs**

1     Battery monitoring electronic
2     battery
3     charge electronic (CE)
4     series resistor
5     differential amplifier
6     analog-to-digital converter
7     numerical integration (NI) block
8     digital interface (DI)
9     functional circuitry
10    purely combinational logic
11    clock gate
12    power switch
13    flip-flop, storage means
14    N-to-1 divider with factor $N_d$
15    Respective domain
16    Accumulator
17    Collection means
18    Voltage selector
19    domain-specific increment register
20    domain scaling factor register
21    voltage multiplexer

**Claims**

1.  A method for metering power consumption of a digital system-on-chip, SoC, for predicting battery life of a battery (2) used by the SoC, the method comprising the following steps:

- Partitioning of all digital circuitry of the SoC into voltage and/or clock domains (15);
- Metering a power consumption of every domain (15) by counting a charge pulse of each domain (15) every time a gate of said domain (15) has been switched;
- Accumulating said counted charge pulses of each domain (15) by an accumulator (16), wherein the value of counted charge pulses of each domain is proportional to its gate-count, the average switching activity, and the square of the domain's voltage;
- Calculating an overall sum R of all charges drained from the battery (2) by said domains (15) of the SoC;
- Post-processing said overall sum R for predicting battery life by an integrated micro-processor;
- Signaling an imminent battery loss.

2. The method for metering power consumption for predicting battery life of a battery (2) used by the SoC according to claim 1, wherein the overall sum R of charges of all domains (15) is calculates by $R = S_d \cdot \sum_i^{pulses} I_d$ , whereas $S_d$ corresponds to a domain scaling factor and $I_d$ corresponds to a domain-specific increment.

3. The method for metering power consumption for predicting battery life of a battery (2) used by the SoC according to claim 2, wherein $I_d$ and $S_d$ represents a combined proportionality factor of the domain (15) and they depend on the gate-count of said domain (15), the switching activity of said domain (15) and the voltage of said domain (15).

4. The method for metering power consumption for predicting battery life of a battery (2) used by the SoC according to claim 3, wherein the gate-count of each domain (15) is fixed at design time of the SoC and the switching activity is determined by netlist simulations at design time or by a calibration step of the SoC.

5. The method for metering power consumption for predicting battery life of a battery (2) used by the SoC according to claims 2 or 3, wherein $I_d$ and/or $S_d$ are adjusted to a current voltage selection of the domain (15), whereas $I_d$ and/or $S_d$ are reprogrammed dynamically by the integrated micro-processor or by an automatic voltage selector (18).

6. The method for metering power consumption for predicting battery life of a battery (2) used by the SoC according to one of the former claims, wherein nested clock domains (15) are handled by identifying an appropriate level of clock domains (15), numerically integrating of their respective activity and averaging over all potential sub-domains.

7. The method for metering power consumption for predicting battery life of a battery (2) used by the SoC according to claim 6, wherein the factors $I_d$ and/or $S_d$ of the sub-domains are determined by netlist simulations at design time or by a calibration step of the SoC.

8. The method for metering power consumption for predicting battery life of a battery (2) used by the SoC according to one of the former claims, wherein a top accumulator is pre-set with a credit reflecting a battery capacity from which the accumulated charges of each domain are subtracted until said credit has expired and the battery has reached its end of life.

9. An apparatus configured to perform the method of metering power consumption of a SoC according to claims 1 to 8, the apparatus is part of the SoC and comprises all digital circuitry of the SoC, wherein said digital circuitry is divided into clock and/or voltage domains (15), whereas each domain (15) is assigned to an accumulator (16) for accumulating counted charge pulses of said domain (15), a collection means (17) for calculating an overall sum R of all charges drained from the battery (2) by said domains (15) of the SoC and a micro-processor for post-processing said overall sum $R$ for predicting battery life of the SoC.

10. The apparatus for performing the method of metering power consumption of a SoC according to claim 9, wherein each domain (15) comprises combinational logic (10), a clock gate (11) for switching a clock, storage means (13) for storing a state between subsequent clock cycles and a N-to-1 divider (14) for providing a counting pulse for the accumulation.

11. The apparatus for performing the method of metering power consumption of a SoC according to claim 9, wherein the accumulator comprises a domain-specific increment register (19).

12. The apparatus for performing the method of metering power consumption of a SoC according to claim 9, wherein the collection means comprises a domain scaling factor register (20).

13. The apparatus for performing the method of metering power consumption of a SoC according to claims 11 or 12, wherein the domain-specific increment register (19) $Incr_x$ and/or the domain scaling factor register (20) $Scale_x$ are programmable registers or ROM-based look-up-tables.

**14.** The apparatus for performing the method of metering power consumption of a SoC according to claim 9, wherein each domain comprises a voltage selector (18) for dynamic voltage scaling.

**Patentansprüche**

1. Verfahren zum Messen des Stromverbrauchs eines digitalen System-on-Chip, SoC, zur Vorhersage einer Batterielaufzeit einer vom SoC verwendeten Batterie (2), wobei das Verfahren die folgenden Schritte umfasst:

   - Aufteilen der gesamten digitalen Schaltungsanordnung des SoC in Spannungs- und/oder Taktdomänen (15);
   - Messen eines Stromverbrauchs jeder Domäne (15) durch Zählen eines Ladungsimpulses jeder Domäne (15) jedes Mal, wenn ein Gate der Domäne (15) geschaltet wurde;
   - Akkumulieren der gezählten Ladungsimpulse jeder Domäne (15) durch einen Akkumulierer (16), wobei der Wert der gezählten Ladungsimpulse jeder Domäne proportional zu ihrer Gate-Anzahl, der durchschnittlichen Schaltaktivität und dem Quadrat der Spannung der Domäne ist;
   - Berechnen einer Gesamtsumme R aller Ladungen, die von den Domänen (15) des SoC aus der Batterie (2) abgezogen wurden;
   - Nachverarbeiten, durch einen integrierten Mikroprozessor, der Gesamtsumme R zur Vorhersage einer Batterielaufzeit;
   - Signalisieren einer bevorstehenden Batterieerschöpfung.

2. Verfahren zum Messen des Stromverbrauchs zur Vorhersage einer Batterielaufzeit einer vom SoC nach Anspruch 1 verwendeten Batterie (2), wobei die Gesamtsumme R der Ladungen aller Domänen (15) durch $R = S_d \cdot \sum_i^{Impulse} I_d$ berechnet wird, wobei $S_d$ einem Domänenskalierungsfaktor und $I_d$ einem domänenspezifischen Inkrement entspricht.

3. Verfahren zum Messen des Stromverbrauchs zur Vorhersage einer Batterielaufzeit einer vom SoC nach Anspruch 2 verwendeten Batterie (2), wobei $I_d$ und $S_d$ einen kombinierten Proportionalitätsfaktor der Domäne (15) darstellen und von der Gate-Anzahl der Domäne (15), der Schaltaktivität der Domäne (15) und der Spannung der Domäne (15) abhängen.

4. Verfahren zum Messen des Stromverbrauchs zur Vorhersage einer Batterielaufzeit einer vom SoC nach Anspruch 3 verwendeten Batterie (2), wobei die Gate-Anzahl jeder Domäne (15) zum Zeitpunkt des Entwurfs des SoC festgelegt wird und die Schaltaktivität durch Netzlistensimulationen zum Zeitpunkt des Entwurfs oder durch einen Kalibrierungsschritt des SoC bestimmt wird.

5. Verfahren zum Messen des Stromverbrauchs zur Vorhersage einer Batterielaufzeit einer vom SoC nach Anspruch 2 oder 3 verwendeten Batterie (2), wobei $I_d$ und/oder $S_d$ an eine aktuelle Spannungswahl der Domäne (15) angepasst werden, während $I_d$ und/oder $S_d$ durch den integrierten Mikroprozessor oder durch einen automatischen Spannungswähler (18) dynamisch neu programmiert werden.

6. Verfahren zum Messen des Stromverbrauchs zur Vorhersage einer Batterielaufzeit einer Batterie (2), die von dem SoC nach einem der vorhergehenden Ansprüche verwendet wird, wobei verschachtelte Taktdomänen (15) behandelt werden, indem eine geeignete Ebene von Taktdomänen (15) identifiziert wird, ihre jeweilige Aktivität numerisch integriert wird und über alle potenziellen Unterdomänen gemittelt wird.

7. Verfahren zum Messen des Stromverbrauchs zur Vorhersage einer Batterielaufzeit einer vom SoC nach Anspruch 6 verwendeten Batterie (2), wobei die Faktoren $I_d$ und/oder $S_d$ der Unterdomänen durch Netzlistensimulationen zum Zeitpunkt des Entwurfs oder durch einen Kalibrierungsschritt des SoC bestimmt werden.

8. Verfahren zum Messen des Stromverbrauchs zur Vorhersage von Batterielaufzeit einer vom SoC nach einem der vorhergehenden Ansprüche verwendeten Batterie (2), wobei ein oberer Akkumulierer mit einem Guthaben voreingestellt wird, das eine Batteriekapazität widerspiegelt, von der die akkumulierten Ladungen jeder Domäne abgezogen werden, bis das Guthaben aufgebraucht und die Batterie erschöpft ist.

9. Vorrichtung, die dafür ausgelegt ist, das Verfahren zum Messen des Stromverbrauchs eines SoC nach einem der Ansprüche 1 bis 8 durchzuführen, wobei die Vorrichtung Teil des SoC ist und die gesamte digitale Schaltungsanordnung des SoC umfasst, wobei die digitale Schaltungsanordnung in Takt- und/oder Spannungsdomänen (15) unterteilt ist, während jede Domäne (15) einem Akkumulierer (16) zum Akkumulieren gezählter Ladungsimpulse der Domäne (15), einem Erfassungsmittel (17) zum Berechnen einer Gesamtsumme R aller aus der Batterie (2) durch die Domänen (15) des SoC abgezogenen Ladungen und einem Mikroprozessor zum Nachverarbeiten der Gesamtsumme R zur Vorhersage einer Batterielaufzeit des SoC zugewiesen ist.

10. Vorrichtung zum Durchführen des Verfahrens zum Messen des Stromverbrauchs eines SoC nach Anspruch 9, wobei jede Domäne (15) kombinatorische Logik (10), ein Taktgatter (11) zum Schalten eines Takts, ein Speichermittel (13) zum Speichern eines Zustands zwischen aufeinanderfolgenden Taktzyklen und einen N-zu-1-Teiler (14) zum Bereitstellen eines Zählimpulses für die Akkumulierung umfasst.

11. Vorrichtung zum Durchführen des Verfahrens zum Messen des Stromverbrauchs eines SoC nach Anspruch 9, wobei der Akkumulierer ein domänenspezifisches Inkrementregister (19) umfasst.

12. Vorrichtung zum Durchführen des Verfahrens zum Messen des Stromverbrauchs eines SoC nach Anspruch 9, wobei das Erfassungsmittel ein Domänenskalierungsfaktorregister (20) umfasst.

13. Vorrichtung zum Durchführen des Verfahrens zum Messen des Stromverbrauchs eines SoC nach Anspruch 11 oder 12, wobei das domänenspezifische Inkrementregister (19) $Incr_x$ und/oder das Domänenskalierungsfaktorregister (20) $Scale_x$ programmierbare Register oder ROM-basierte Nachschlagetabellen sind.

14. Vorrichtung zum Durchführen des Verfahrens zum Messen des Stromverbrauchs eines SoC nach Anspruch 9, wobei jede Domäne einen Spannungswähler (18) zur dynamischen Spannungsskalierung umfasst.

**Revendications**

1. Procédé de mesure de la consommation électrique d'un système sur puce, SOC, numérique pour prédire l'autonomie d'une batterie (2) utilisée par le SOC, le procédé comprenant les étapes suivantes :

   - le partitionnement de tous les circuits numériques du SOC en domaines de tension et/ou d'horloge (15) ;
   - la mesure d'une consommation électrique de chaque domaine (15) en comptant une impulsion de charge de chaque domaine (15) chaque fois qu'une porte dudit domaine (15) a été commutée ;
   - le cumul desdites impulsions de charge comptées de chaque domaine (15) par un accumulateur (16), dans lequel la valeur des impulsions de charge comptées de chaque domaine est proportionnelle à son compte de portes, à l'activité de commutation moyenne et au carré de la tension du domaine ;
   - le calcul d'une somme globale R de toutes les charges drainées de la batterie (2) par lesdits domaines (15) du SOC ;
   - le post-traitement de ladite somme globale R pour prédire l'autonomie par un microprocesseur intégré ;
   - la signalisation d'une perte imminente de la batterie.

2. Procédé de mesure de la consommation électrique pour prédire l'autonomie d'une batterie (2) utilisée par le SOC selon la revendication 1, dans lequel la somme globale R des charges de tous les domaines (15) est calculée par

$$R = S_d \cdot \sum_{i}^{impulsions} I_d,$$ où $S_d$ correspond à un facteur d'échelle de domaine et $I_d$ correspond à un incrément spécifique au domaine.

3. Procédé de mesure de consommation électrique pour prédire l'autonomie d'une batterie (2) utilisée par le SOC selon la revendication 2, dans lequel $I_d$ et $S_d$ représentent un facteur de proportionnalité combiné du domaine (15) et dépendent du compte de portes dudit domaine (15), de l'activité de commutation dudit domaine (15) et de la tension dudit domaine (15).

4. Procédé de mesure de consommation électrique pour prédire l'autonomie d'une batterie (2) utilisée par le SOC selon la revendication 3, dans lequel le compte de portes de chaque domaine (15) est fixé au moment de la conception du SOC et l'activité de commutation est déterminée par des simulations de liste d'interconnexions au moment de la conception ou par une étape d'étalonnage du SOC.

**5.** Procédé de mesure de consommation électrique pour prédire l'autonomie d'une batterie (2) utilisée par le SOC selon les revendications 2 ou 3, dans lequel $I_d$ et/ou $S_d$ sont ajustés à une sélection de tension actuelle du domaine (15), tandis que $I_d$ et/ou $S_d$ sont reprogrammés dynamiquement par le micro-processeur intégré ou par un sélecteur automatique de tension (18).

**6.** Procédé de mesure de consommation électrique pour prédire l'autonomie d'une batterie (2) utilisée par le SOC selon l'une des revendications précédentes, dans lequel des domaines d'horloge imbriqués (15) sont traités en identifiant un niveau approprié de domaines d'horloge (15), intégrant numériquement leur activité respective et établissant une moyenne sur tous les sous-domaines potentiels.

**7.** Procédé de mesure de consommation électrique pour prédire l'autonomie d'une batterie (2) utilisée par le SOC selon la revendication 6, dans lequel les facteurs $I_d$ et/ou $S_d$ des sous-domaines sont déterminés par des simulations de liste d'interconnexions au moment de la conception ou par une étape d'étalonnage du SOC.

**8.** Procédé de mesure de consommation électrique pour prédire l'autonomie d'une batterie (2) utilisée par le SOC selon l'une des revendications précédentes, dans lequel un accumulateur supérieur est préréglé avec un crédit reflétant une capacité de batterie de laquelle sont soustraites les charges cumulées de chaque domaine jusqu'à ce que ledit crédit ait expiré et que la batterie ait atteint sa fin de vie.

**9.** Appareil configuré pour réaliser le procédé de mesure de consommation électrique d'un SOC selon les revendications 1 à 8, l'appareil fait partie du SOC et comprend tous les circuits numériques du SOC, dans lesquels lesdits circuits numériques sont divisés en domaines d'horloge et/ou de tension (15), tandis que chaque domaine (15) est assigné à un accumulateur (16) pour cumuler des impulsions de charge comptées dudit domaine (15), un moyen de collecte (17) pour calculer une somme globale R de toutes les charges drainées de la batterie (2) par lesdits domaines (15) du SOC et un micro-processeur pour le post-traitement de ladite somme globale R afin de prédire l'autonomie du SOC.

**10.** Appareil de réalisation du procédé de mesure de consommation électrique d'un SOC selon la revendication 9, dans lequel chaque domaine (15) comprend une logique combinatoire (10), une porte d'horloge (11) pour la commutation d'une horloge, un moyen de stockage (13) pour stocker un état entre des cycles d'horloge suivants et un diviseur N-à-1 (14) pour fournir une impulsion de comptage pour le cumul.

**11.** Appareil de réalisation du procédé de mesure de consommation électrique d'un SOC selon la revendication 9, dans lequel l'accumulateur comprend un registre à incrément spécifique au domaine (19).

**12.** Appareil de réalisation du procédé de mesure de consommation électrique d'un SOC selon la revendication 9, dans lequel le moyen de collecte comprend un registre de facteurs d'échelle de domaine (20).

**13.** Appareil de réalisation du procédé de mesure de consommation électrique d'un SOC selon les revendications 11 ou 12, dans lequel le registre à incrément spécifique au domaine (19) $Incr_x$ et/ou le registre de facteurs d'échelle de domaine (20) $Scale_x$ sont des registres programmables ou des tables de consultation basées sur ROM.

**14.** Appareil de réalisation du procédé de mesure de consommation électrique d'un SOC selon la revendication 9, dans lequel chaque domaine comprend un sélecteur de tension (18) pour une mise à l'échelle dynamique de la tension.

FIG 1    State of Art

FIG 2

## FIG 3

## FIG 4

# FIG 5

FIG 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20130151228 A1

- EP 2670034 A1